# EUROPEAN PATENT SPECIFICATION

(11) **EP 2 323 186 B1**
(45) Date of publication and mention of the grant of the patent: **26.07.2017**
(21) Application number: 09179014.7
(22) Date of filing: 14.12.2009
(51) Int. Cl.: H01L 33/54, H01L 33/48, H01L 33/56

(54) **Light-emitting diode module and corresponding manufacturing method**
Leuchtdiodenmodul und entsprechendes Herstellungsverfahren
Module de diode électroluminescente et son procédé de fabrication

(30) Priority: 13.11.2009 EP 09175958
(43) Date of publication of application: 18.05.2011
(73) Proprietor: Tridonic Jennersdorf GmbH, 8380 Jennersdorf (AT)
(72) Inventor: Knaus, Jürgen, 8380 Jennersdorf (AT); Werkovits, Martin, 8380 Jennersdorf (AT); Tauterer, Hannes, 8312 Ottendorf (AT)
(74) Representative: Rupp, Christian

(56) References cited:
- JP-A- 6 232 457
- JP-A- 2000 002 802
- US-A1- 2007 029 569
- US-A1- 2007 155 033
- US-A1- 2007 170 454
- US-A1- 2008 023 711
- US-A1- 2009 065 792
- US-A1- 2009 186 454
- US-B1- 6 489 637

## Description

The present invention is defined in independent claims 1 and 13 and discloses a light-emitting diode (LED) module and a corresponding manufacturing method. In particular the invention discloses an LED module employing an essentially half-spherical cover layer ("globe-top") covering the LED and the method for covering the LED with the globe-top.

LEDs disposed on a LED module are usually covered or packaged to prevent them from becoming damaged or contaminated while shipping, installing and operating. Several packaging or covering methods have been employed to cover LEDs in a module, like plastic molding, liquid filling or the so-called globe-top method.

The globe-top method is usually used for a chip-on-board assembly of the LEDs, where a plurality of LEDs is attached to a substrate and the LEDs are electrically connected to the substrate. The globe-top is a drop of a specially formulated resin, which is deposited over the LED chip on the substrate and the attached the wire bonds. The globe-top protects the LED chip beneath, provides mechanical support, and excludes containments or dirt, which could disturb the functionality of the LED circuitry.

When using the globe-top technique to cover LEDs on a substrate, either transparent materials or, materials which include phosphor particles are chosen. For example to create white light, e.g. blue LEDs are attached to the substrate and are covered with a globe-top which comprises phosphor material. When the light emitted from the LED is excites the phosphor material, the phosphor material emits light in a different wavelength range. The combination of the LED wavelength and the wavelength emitted from the phosphor material creates light, which appears white to the human eye, if the appropriate phosphor material is chosen.

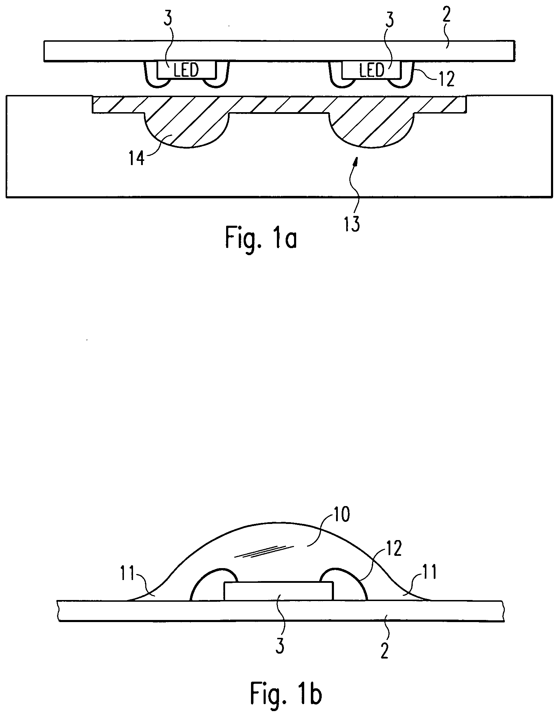

In state of the art, half-spherical cover layers, so-called globe-tops are usually realized by a so-called overmoulding process. Fig. 1a shows an example of how the overmoulding process is performed. One or more LED chips 3 are mounted to a substrate 2 and are electrically connected to the substrate via wire bonds 12. A globe-top, usually made of silicone material(s), is deposited over each LED, directly onto the substrate. Therefore, an overmoulding form 13, which comprises at least one cavity, which is filled with a resin 14, is positioned to the substrate, so that the resin-filled cavity is positioned directly over the LED chip 3. By thermal processing, while the overmoulding form 13 is pressed to the substrate 2, the resin 14 is hardened and the overmoulding form 13 can be removed. The resin 4 remains attached to the substrate 2 in a half-spherical shape resembling the cavities of the overmoulding form 13, and covers the LED chip 3 and nearby parts of the substrate 2.

However, such an overmoulding process exhibits various disadvantages. First of all, overmoulding machines are expensive. Thus the price per manufactured LED module is increased. Secondly, during the pressing of the overmoulding form towards the substrate, deformations or damages of the bonding wire and/or of the LED attached to the substrate can occur. Thereby, the yield of the manufacturing process for the LED modules is decreased.
A state of art LED module with a dispensed globe-top is shown in Fig. 1b. A LED chip 3 is mounted to a substrate 2, and a dispensed "globe-top" 10 is disposed to cover the LED chip 3. The interface angle at the interface 11 between the substrate and the globe-top 10 is much smaller than 90°, due to the differences in surface energies the globe-top 10 is broadened at its outer edges at said interface.

The disadvantage when using the state of the art dispensing process is that the substrate and the globe-top, which is usually made from silicone, have different surface energies. As a consequence the half-spherical globe-tops cannot be disposed to cover the LEDs in such a way, that the interface angle between the substrate and the globe-top reaches 90°.

The smaller than 90° interface angle degrades the emission characteristics of the LED module. Especially emission characteristics in respect to emission angle are not homogenous. When creating white LEDs, this can lead to disturbing differences in color temperature of an LED module depending on the viewing angle.

US 2008/023711 A1 (TARSA ERIC [US] ET AL; 31 January 2008) discloses a method for forming an LED package comprising providing a substrate with a first meniscus ring on a surface of the substrate. An LED chip is mounted to the substrate, within the meniscus ring. An inner material is deposited over the LED chip, and a lens material in liquid form is deposited over the inner material. The lens material is held in a hemispheric shape by the first meniscus ring and the lens material is cured making it harder than the inner material.

JP 6 232457 A (SANYO ELECTRIC CO; TOKYO SANYO ELECTRIC CO; 19 August 1994) discloses an arrangement of light-emitting diodes provided on electrodes on a substrate, a coating resin of low viscosity covering the electrodes and the light-emitting diodes, and a transparent silicone resin of high viscosity covering the coating resin, wherein the contact angle at the interface between the silicone resin and the coating resin is relatively small.

Therefore, the object of the present invention is to overcome the disadvantages mentioned above. In particular, it is the object of the present invention to provide a cheaper method of manufacturing LED modules, which increase the yield and improve the emission characteristics. In particular, the object is to provide a manufacturing method and the corresponding LED module, which employs the dispensing globe-top technique but allows the formation of an interface angle of ideally 90°. The objective problems are solved by the independent claims of the present invention.

A manufacturing method according to the present invention produces a light emitting diode module preferably producing white light. The method comprises the steps of: mounting at least one LED onto a surface of a substrate, depositing a base layer to completely cover said substrate surface and the LED, wherein the base layer is transparent for visible light and preferably does not comprise phosphor particles, a first heat treatment to modify the surface properties of the base layer, dispensing a matrix material, so that it forms an essentially half-spherical cover ("globe top") covering the LED and nearby portions of the base layer, and a second heat treatment to harden the half-spherical cover layer.

Preferably the base layer, at least after the treatment, and the matrix material of the essentially half-spherical cover have equal or at least comparable surface energies.

With the manufacturing method according to the present invention, a cheaper solution is achieved. In contrast to the state of the art overmoulding process, no overmoulding machine and overmoulding form, which are very expensive, have to be built or bought. Thereby, the cost per LED module can be significantly decreased. Further, since no overmoulding form has to be pressed onto the LED during the manufacturing process, damage can be avoided and the yield of the LED modules is improved. Especially, operation failure rate due to bonding wire breakage or its loose connection is significantly decreased. Finally, by applying the base layer, the depositing step of the cover layer produces half-spherical shapes with interface angles close to 90°. It's taken an advantage of the application of nearly perfect half-spherical globe-tops applied on the LED modules to improve their emission characteristics.

Preferably the step of depositing the base layer is a single-step, e.g. realized by dip-coating or spin-coating. Other known coating techniques like spraying could be applied as well.

The manufacturing process is shortened, which reduces the costs per LED module. The formed base layer has a relatively homogenous thickness.

Preferably the step of depositing the base layer is a multi-step, in which small droplets of the base layer material are dispensed in consecutive steps.

Thereby, the base layer can be produced more thoroughly, and possible voids or other defects are avoided. Moreover, the amount of base layer material can be individually varied for each droplet, for example for covering the substrate and for covering the LED, where more base layer material might be required.

Preferably the step of depositing the base layer comprises a step of incorporating filler particles, e.g silica, alumina, titania, zirconia, barium titanate and/or barium sulphate, into the base layer material.

Also the cover layer can comprise the filler particles mentioned above. Filler particles modify the rheological properties of the base and/or cover layer. The depositing steps of the base and/or cover layers can thus be optimized, for examples in terms of speed and/or yield.

Preferably the viscosity of the base layer material is in a range of 1 Pa·s to 4 Pa·s at a shear rate of 0.94 s⁻¹.

This value is optimal for the depositing step in terms of speed and yield. Regarding the targeted surface coverage, its thickness and homogeneity the indicated viscosity rage, which presents excellent flowability, is chosen.

Preferably the first heat treatment step is performed at approximately 80°C for approximately 1 hour.

Preferably the second heat treatment step is performed at approximately 150°C for approximately 1 hour.

Preferably the cover layer material is dropped onto the LED (2) and nearby portions of the base layer (5).

Dropping of the cover layer material is resulted in the formation of half-spherical shaped globe-tops with excellent emission properties.

Preferably the viscosity of the cover layer material is in a range of 40 Pa·s to 85 Pa·s at a shear rate of 0.94 s⁻¹,

The value is an optimum for the depositing step in terms of speed and yield.

Preferably, the matrix material comprises phosphor and/or scattering particles.

Preferably, the LED is a monochromatic and/or a thin phosphor film covered LED.

If the LED is a monochromatic LED and the matrix material comprises no phosphor particles, a monochromatic LED module is obtained. If the matrix material comprises phosphor particles, a white light emitting LED module can be obtained even with a monochromatic LED. Another possibility to achieve a white light emitting LED module is to use thin phosphor film covered LEDs. In this case the matrix material can optionally comprise additional phosphor particles. Such thin film phosphor-converted light emitting diode devices are known e.g. from US 6696703, US 6501102 and US 6417019. A light emitting diode module preferably producing white light according to the present invention is obtainable by a method as described by the steps above. The light emitting diode module can be manufactured with monochromatic LEDs and/or thin phosphor film covered LEDs, as described above, and exhibits all mentioned advantages. A light emitting diode module preferably producing white light according to the present invention comprises a substrate, at least one LED mounted onto a surface of the substrate, a base layer, which is transparent to visible light and preferably does not comprise phosphor particles, covering in intimate contact the complete substrate surface and the LED, at least one essentially half-spherical cover layer, which covers the LED and nearby portions of the base layer.

The light emitting diode module exhibits emission characteristics, which are improved over state of the art LED modules. Due to the base layer beneath the cover layer, an interface angle between base layer and cover layer is improved. Due to the resulted the more close to half-spherical shaped cover layer, the emission characteristics of the LED module, especially over a range of viewing angles, is improved. Efficiency of the light out-coupling of the LEDs (e.g. thin phosphor film covered LEDs and/or monochromatic LEDs) got significantly increased. For the preferred white light emission, a more homogenous color temperature depending on the viewing angle can be achieved.

Preferably the interface angle between the base layer and the half-spherical cover layer approaches 90°.

An angle of 90° represents a perfect half-sphere. Thus the best emission characteristics for the LED module are possible.

Preferably the substrate is a printed circuit board, PCB. Preferably the LED is electrically connected to the substrate by at least one bond wire.

The thickness of the base layer is in a range from 100 µm to 500 µm, preferably in a range from 200 µm to 400 µm.

The above mentioned thickness represents the best compromise between manufacturing costs (thin base layer) and homogeneity of the base layer (thicker base layer).

Preferably the base layer is a two-component silicone resin.

Preferably the base layer (5) and/or the cover layer (6) comprise(s) filler particles, e.g silica, alumina, titania and/or zirconia.

The maximum height of the half-spherical cover layer is preferably in a range from 500 µm to 1400 µm, more preferably in a range from 600 µm to 1300 µm.

The above mentioned height achieves the best emission characteristics and light out-coupling efficiency. Moreover above mentioned half-spheres can be reliably produced in the manufacturing process of the LED module.

The width of the LED is preferably in a range from 300 µm to 1000 µm.

Preferably the at least one essential half-spherical cover layer comprises phosphor particles and/or scattering particles.

Preferably the LED is a monochromatic and/or a thin phosphor film covered LED.

If the LED is a monochromatic LED and the half-spherical cover layer comprises no phosphor particles, a monochromatic LED module is obtained. If the half-spherical cover layer comprises phosphor particles, a white light emitting LED module can be obtained even with a monochromatic LED. Another possibility to achieve a white light emitting LED module is to use thin phosphor film covered LEDs. In this case the half-spherical cover layer optionally can comprise additional phosphor(s).

The present invention will be described in more details below, in reference to the attached drawings, wherein:
- Fig. 1a: shows a state of the art overmoulding process.
- Fig. 1b: shows a state of the art LED module with a dispensed and cured, essentially half-spherical transparent cover ("globe-top").
- Fig. 2: shows an LED module according to the present invention.
- Fig. 3: shows an optical image of an LED module of the present invention.
- Fig. 4: shows emission curves of state of the art LED modules and LED modules according to the present invention.
- Fig. 5: shows a thin phosphor film covered LED.

In the following, the LED module and the corresponding manufacturing method are described.

Initially, at least one LED 3 is mounted onto a substrate 2. Preferably, the substrate 2 is a printed circuit board (PCB). However, the substrate can also be any kind of substrate, which comprises at least some conducting parts on its surface. This can be realized by metal paths or wiring on the substrate 2 surface. The LED 3 is connected electrically via wire bonds 12 to conducting paths on the substrate 2 surface. Preferably special bond pads are present on the substrate 2 surface, onto which the bonding wires 4 can be bonded. The bonding wires 12 are made of a conductive metal, preferably gold. Via the bonds wires 12 the LED chips 3 can be controlled and can be supplied with power.

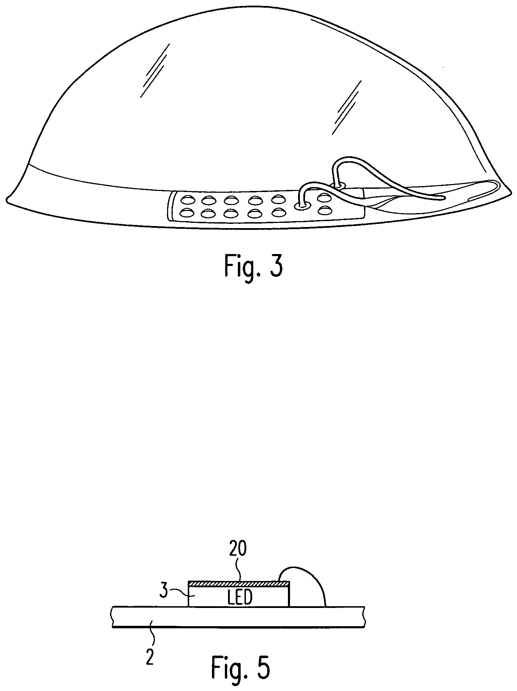

All available kinds of LEDs 3 or organic LEDs (OLEDs) can be used. The LEDs 3 can be monochromatic and/or can be LEDs coated with a thin phosphor film. A thin phosphor film 20 covered LED mounted onto a substrate is shown in Fig. 5. The LED 3 is not restricted to a certain color. Preferably, however, blue LEDs are chosen, if the LED module 1 is to emit white light. The power supply of the LEDs 3 can be realized by an AC- or DC-voltage or also an emergency voltage. With the LED chip 3 also a driving circuit can be included to operate the LEDs 3.

In a next step, a base layer 5 is deposited onto the LED 3 and onto the substrate 2. The base layer 5 covers at least the complete top surface of the substrate 2 and completely covers the LED 3 and also the bond wires 12 (i.e. the bond wires 12, which preferably form an arc with an apex extending higher than the top surface of the LED chip 3, are completely enclosed in the base layer 5).

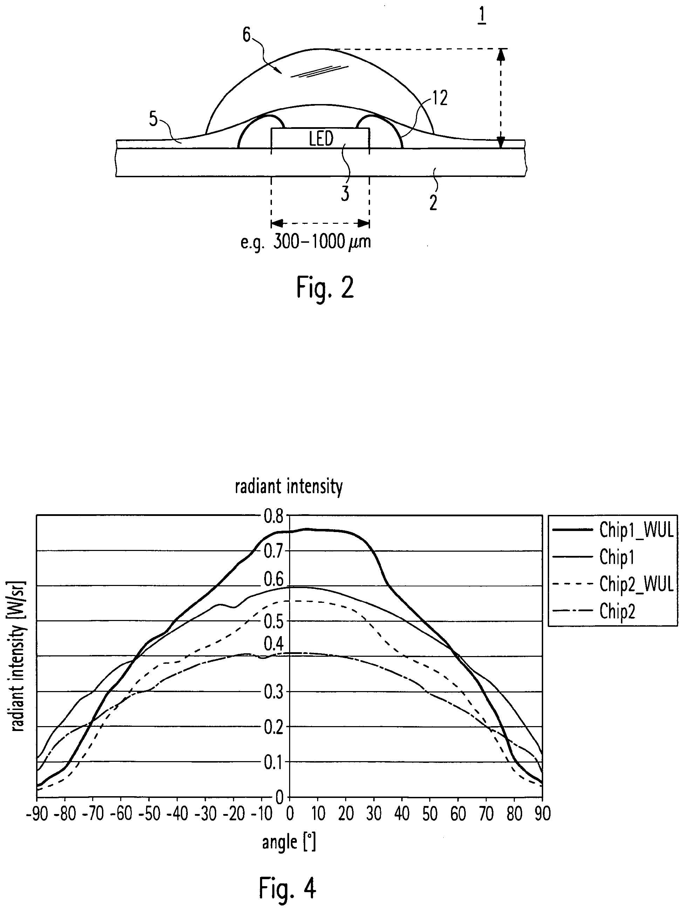

The base layer 5 is preferably 100 to 500 µm thin, more preferably 200 to 400µm thin. As shown in Fig. 2, the base layer 5 can have an inhomogeneous thickness, being thicker where the LED chip 3 is positioned in comparison to areas outside the contours of the LED chip 3 (when seen from above).

As base layer 5 material a transparent material is chosen, which preferably shows nearly perfect transmittance over a large wavelength range. The base layer 5 material is at least transparent in the visible wavelength range. The base layer material is preferably a two-component silicone resin. However, other materials with similar properties can be used. As an example, the silicone resin can be the IVS4312 resin obtainable from 'Momentive Performance Materials'. IVS4312 is an example for a two-component, transparent, liquid, addition cure silicone resin.

The base layer 5 material preferably shows a low viscosity, to provide excellent flowability during the deposition step. The viscosity of the material at a shear rate of about 0.94 s⁻¹ is between 1 Pa·s and 10 Pa·s. More preferably, the viscosity is between 1 Pa·s and 4 Pa·s.

The base layer 5 can be deposited onto the substrate 2 and the LED 3 by either a single step or by multiple steps. In a single step, for example dip-coating or spin-coating of the base layer 5 material onto the substrate 2 and the LED 3 is performed. Thereby, both the top and the bottom surface of the substrate 2 are covered with the base layer 5. As an example for multiple steps, dispensing of small droplets of the base layer 5 material in consecutive steps onto the LED 3 and substrate 2 can be performed. The procedure is repeated until the complete top surface of the substrate 2 is covered by a continuous base layer 5. The above-mentioned depositing methods are examples and also other methods can be applied, which lead to the same results.

During the depositing of the base layer 5, the base layer 5 material can be provided additionally with filler particles. Filler particles can be used to further adjust the rheological properties of the resin. Rheological properties are for example the flow properties of fluids, or the deformation properties of solids under stress or strain. As filler particles for example silica (SiO₂), alumina (Al₂O₃), titania (TiO₂), and/or zirconia (ZrO) can be used. The filler particles are not incorporated into the purchased silicone resin, but are incorporated into the resin prior to the depositing step of the base layer 5. Especially the viscosity of the base layer 5 can be adjusted more precisely and in a wide range by adding filler particles.

In a next step the base layer 5 can be thermally treated. Thereby the surface properties of the base layer 5 can be modified. Preferably, the heat treatment is performed at 80°C for one hour.

In a next step at least one essentially half-spherical cover layer (globe-top) 6 is dispensed, so that it covers the LED 3 and optionally nearby portions of the base layer 5. Preferably when forming the globe-top 6 a silicone resin is used, and is dropped or dispensed onto the position where the LED 3 is located on the substrate 2. The cover layer 6 material is preferably a two-component silicone resin. However, other materials with similar properties can be used. As an example, the silicone resin can be the IVS4632 resin obtainable from 'Momentive Performance Materials'. IVS4632 is a two-component, addition cure silicone resin.

The cover layer 6 can comprise phosphor particles and/or scattering particles, so as to alter the properties of the light, which is emitted by the LED 3. Especially if a white light LED module 1 is constructed, phosphor particles are chosen, which emit in a wavelength range, which combines with the wavelength emitted from the LED 3 to a color visible as white light for the human eye. Scattering particles can diffuse the light to achieve a more homogeneous and pleasant light of the LED module 1. In contrast to the cover layer 6, which can comprise phosphor particles, the base layer 5 preferably does not comprise phosphor particles.

During the depositing of the cover layer 6, the cover layer 6 material can be provided additionally with filler particles. Filler particles can be used to further adjust the rheological properties of the resin. Rheological properties are for example the flow properties of fluids, or the deformation properties of solids under stress or strain. As filler particles for example silica (SiO₂), alumina (Al₂O₃), titania (TiO₂), and/or zirconia (ZrO) can be used. The filler particles are not incorporated into the purchased silicone resin(s), but are incorporated into the resin prior to the depositing step of the cover layer 6. Especially the viscosity of the cover layer 5 can be adjusted more precisely and in a wide range by adding filler particles.

The cover layer 6 is disposed onto the LED 3, so that the complete LED 3 is covered. The width of an LED 3 is preferably in a range of 300 to 1000 µm. The width of the cover layer 6 is preferably larger than the width of the LED 3, to optionally also cover nearby portions of the base layer 5, which itself is covering the LED 3 and the substrate 2. The amount of cover layer 6 material is chosen, so that the height of the half-spherical cover layer 6 is in a range between 500 to 1400 µm, more preferably in a range from 600 to 1300 µm.

The cover layer 6 material preferably shows rheological properties of a viscosity in a range of 40 to 85 Pa·s at a shear rate of 0.94 s⁻¹. Moreover, a storage modulus of 700 to 1100 Pa is preferred.

As final optional step a heat treatment can be performed at a temperature of 150 °C for one hour, to harden the cover layer 6.

With the above described method, the LED module 1 shown in Fig. 2 can be manufactured. The LED module in Fig. 2 shows the substrate 2, the LED 3, the bond wires 4, the base layer 5, which covers the substrate 2 and the LED 3, and the half spherical cover layer 6. The half spherical cover layer 6 preferably comprises phosphor particles and/or scattering particles, and covers the LED 3 and optionally also nearby portions of the base layer. Preferably, in case more than one LED is disposed inside the LED module 1, each half-spherical cover layer 6 covers one LED. However, the invention is not restricted thereto, and also more than one LED 3 can be covered by one half-spherical cover layer 6.

The LED module 1 can be manufactured such, that the interface angle between the base layer 5 and the cover layer 6 approaches 90°. This is due to the surface properties of the base layer 5. If, as in state of the art, a globe-top is deposited directly onto the substrate 2, due to the different surface energies of the substrate 2 and the globe-top, interface angles of close to 90° cannot be reached. By applying the base layer 5 and optionally modifying the surface properties by use of a thermal process, the interface surface energies become comparable. Additionally, low viscosity cover layer 6 materials support the generation of nearly half-spherical globe-tops. They are simply more stable in shape prior to and during the second heat treatment process. Thus, an interface angle of at least 80°, preferably 85°, and more preferably approaching 90° can be realized. Fig. 3 shows an optical image of the LED module 1. Especially the half-spherical globe-top 6 is clearly visible. It can be observed that the interface angle of the half-spherical cover layer 6 and the base layer 5 approaches 90°.

Due to the improved implementation of the half-spherical globe-top 6, the emission characteristics are improved. The more the globe-tops resemble a perfect half-sphere, the better the efficiency of the light emission becomes. Especially, the efficiency at larger emission angles can be greatly improved.

Fig. 4 shows a comparison of emission curves of LED modules 1 of the present invention and state of the art LED modules comprising simple dispensed globe-top covered LEDs, as shown in Fig. 1b and described above. Two different LED modules 1 have been compared, denominated with Chip1 and Chip2 in the Fig. 4. Thereby, the curves denominated with Chip1_WUL and Chip2_WUL, respectively, are emission curves of LED modules 1 according to the present invention including a base layer 5 and a half-spherical shaped cover layer 6. The curves denominated with Chip 2 and Chip1 are emission curves of LED modules without a base layer 5 according to state of the art. On the horizontal axis of the graph illustrated in Fig. 4, the emission angle of the emitted light is indicated. With the vertical axis the radiant intensity in units of W/sr is indicated.

It can be clearly observed that the radiant intensity in the whole range is higher for the two LED modules 1 with the additional base layer 5 produced by the method of the present invention. The two emission curves of state of the art LED modules show a lower radiant intensity. Especially in the middle sections of the curve (between emission angles of -5° to 20°) in comparison with standard state of the art globe-top LED modules, the LED modules 1 according to the present invention show an enhancement of ca. 25% in radiation intensity.

In summary, a new method has been described by the present invention to manufacture a new and inventive LED module 1. By depositing an additional base layer 5, which covers a substrate 2 and at least one LED 3, in combination with an optional heat treatment the surface properties of the base layer 5 and the cover layer 6 can be made nearly equal.

Subsequently, a dispensed cover layer 6 in the form of a half-spherical globe-top, which covers the LED 3 and optionally nearby portions of the base layer 5, can be formed in an improved manner. The method does not require the state of the art overmoulding process, which reduces the costs of each LED module, and also improves the yield, because possible damage in the manufacturing process is prevented. The application of the method is resulted in an almost perfectly half-spherical shaped globe-top 6, which significantly improves the efficiency of the light out-coupling of the LED in comparison to the state of art globe-top dispensing technique.

Furthermore, the emission characteristics of the LED module 1 according to the present invention can be enhanced. Especially an angle dependent radiant intensity can be improved. Due to the fact that the formation of improved interface angles between the base layer 5 and the cover layer 6 are reachable with the method of the present invention (approaching 90°), a more homogeneous emitted light distribution can be achieved. Especially for white LED modules 1, a more homogeneous color temperature of the white light over a large angle can be realized.

## Claims

1. Manufacturing method for a light emitting diode module (1), the method comprising the steps of:
mounting at least one LED (3) onto a surface of a substrate (2);
depositing a base layer (5) to completely cover said substrate (2) surface and the LED (3), wherein the base layer (5) is transparent for visible light and wherein the thickness of the base layer (5) is in a range from 100 µm to 500 µm;
a first heat treatment to modify the surface properties of the base layer (5);
dispensing a matrix material, so that it forms an essentially half-spherical cover layer(6) covering the LED and nearby portions of the base layer (5);
wherein an interface angle between the base layer (5) and the essentially half-spherical cover layer (6) is in the range of 80° to 90°; and a second heat treatment to harden the half-spherical cover layer (6).

2. Manufacturing method according to claim 1, wherein the base layer does not comprise phosphor particles.

3. Manufacturing method according to claim 1 or 2, wherein the step of depositing the base layer (5) is a single-step, e.g. realized by dip-coating or spin-coating.

4. Manufacturing method according to any of the claims 1 to 3, wherein the step of depositing the base layer (5) is a multi-step, in which small droplets of the base layer material are dispensed in consecutive steps.

5. Manufacturing method according to any of the claims 1 to 4, wherein the step of depositing the base layer (5) comprises a step of incorporating filler particles, e.g silica, alumina, titania and/or zirconia, into the base layer material.

6. Manufacturing method according to any of the claims 1 to 5, wherein in the step of depositing the base layer (5) the viscosity of the base layer material is in a range of 1 Pa·s to 4 Pa·s at a shear rate of 0.94 s⁻¹.

7. Manufacturing method according to any of the claims 1 to 6, wherein the first heat treatment step is performed at approximately 80°C for approximately 1 hour.

8. Manufacturing method according to any of the claims 1 to 7, wherein the second heat treatment step is performed at approximately 150°C for approximately 1 hour.

9. Manufacturing method according to any of the claims 1 to 8, wherein in the step of dispensing the cover layer (6), the viscosity of the cover layer material is in a range of 40 Pa·s to 85 Pa·s at a shear rate of 0.94 s⁻¹.

10. Manufacturing method according to any of the claims 1 to 9, wherein the step of depositing the cover layer (6) comprises a step of incorporating filler particles, e.g silica, alumina, titania and/or zirconia, into the base layer material.

11. Manufacturing method according to any of the claims 1 to 10, wherein the matrix material comprises phosphor and/or scattering particles.

12. Manufacturing method according to any of the claims 1 to 11, wherein the LED (3) is a monochromatic and/or a thin phosphor film covered LED.

13. Light emitting diode module (1) comprising
a substrate (2);
at least one LED (3) mounted onto a surface of the substrate (2);
a base layer (5), which is transparent to visible light, said base layer (5) covering in intimate contact the complete substrate (2) surface and the LED (3) and having a thickness in a range from 100 µm to 500 µm;
at least one essentially half-spherical cover layer (6), which covers the LED (3) and nearby portions of the base layer (5);
wherein an interface angle between the base layer (5) and the essentially half-spherical cover layer (6) is in the range of 80° to 90°.

14. LED module (1) according to claim 13, wherein the substrate is a printed circuit board, PCB.

15. LED module (1) according to claim 13 or 14, wherein the LED (3) is electrically connected to the substrate (2) by at least one bond wire (4).

16. LED module (1) according to claims 13 to 15, wherein the base layer (5) is a two-component silicone resin.

17. LED module (1) according to any of the claims 13 to 16, wherein the base layer (5) and/or the cover layer (6) comprises filler particles, e.g silica, alumina, titania and/or zirconia.

18. LED module (1) according to any of the claims 13 to 17, wherein the maximum height of the essentially half-spherical cover layer (6) is preferably in a range from 500 µm to 1400 µm, more preferably in a range from 600 µm to 1300 µm.

19. LED module (1) according to any of the claims 13 to 18, wherein the width of the LED (3) is preferably in a range from 300 µm to 1000 µm.

20. LED module (1) according to any of the claims 13 to 19, wherein the at least one essentially half-spherical cover layer (6) comprises phosphor particles and/or scattering particles.

21. LED module (1) according to any of the claims 13 to 20, wherein the LED (3) is a monochromatic and/or a thin phosphor film (20) covered LED.

22. LED module (1) according to any of the claims 13 to 21, wherein the base layer (5) does not comprise phosphor particles.

## Patentansprüche

1. Herstellungsverfahren für ein Leuchtdioden-Modul (1), wobei das Verfahren folgende Schritte umfasst:
Montieren mindestens einer LED (3) auf eine Oberfläche eines Substrats (2),
Abscheiden einer Grundschicht (5), um die Oberfläche des Substrats (2) und die LED (3) vollständig zu bedecken, wobei die Grundschicht (5) für sichtbares Licht durchlässig ist und wobei die Dicke der Grundschicht (5) im Bereich von 100 bis 500 µm liegt,
eine erste Wärmebehandlung, um die Oberflächeneigenschaften der Grundschicht (5) zu modifizieren,
Ausgeben eines Matrixmaterials derart, dass dieses eine im Wesentlichen halbkugelförmige Deckschicht (6) bildet, welche die LED und nahe gelegene Abschnitte der Grundschicht (5) bedeckt,
wobei ein Winkel des Übergangs von der Grundschicht (5) zur im Wesentlichen halbkugelförmigen Deckschicht (6) im Bereich von 80 bis 90° liegt, und
eine zweite Wärmebehandlung, um die halbkugelförmige Deckschicht (6) zu härten.

2. Herstellungsverfahren nach Anspruch 1, wobei die Grundschicht keine Phosphorpartikel umfasst.

3. Herstellungsverfahren nach Anspruch 1 oder 2, wobei der Schritt des Abscheidens der Grundschicht (5) ein einzelner Schritt ist, der z. B durch Tauchbeschichten oder Rotationsbeschichten umgesetzt wird.

4. Herstellungsverfahren nach einem der Ansprüche 1 bis 3, wobei der Schritt des Abscheidens der Grundschicht (5) ein Schritt mit mehreren Vorgängen ist, in dem kleine Tröpfchen des Materials der Grundschicht in aufeinanderfolgenden Schritten ausgegeben werden.

5. Herstellungsverfahren nach einem der Ansprüche 1 bis 4, wobei der Schritt des Abscheidens der Grundschicht (5) einen Schritt des Einarbeitens von Füllstoffpartikeln, z. B. Siliziumoxid, Aluminiumoxid, Titanoxid und/oder Zirkoniumoxid, in das Material der Grundschicht umfasst.

6. Herstellungsverfahren nach einem der Ansprüche 1 bis 5, wobei beim Schritt des Abscheidens der Grundschicht (5) die Viskosität des Materials der Grundschicht bei einer Schergeschwindigkeit von 0,94 s⁻¹ bei 1 bis 4 Pa·s liegt.

7. Herstellungsverfahren nach einem der Ansprüche 1 bis 6, wobei der Schritt der ersten Wärmebehandlung etwa 1 Stunde lang bei etwa 80 °C ausgeführt wird.

8. Herstellungsverfahren nach einem der Ansprüche 1 bis 7, wobei der Schritt der zweiten Wärmebehandlung etwa 1 Stunde lang bei etwa 150 °C ausgeführt wird.

9. Herstellungsverfahren nach einem der Ansprüche 1 bis 8, wobei beim Schritt des Ausgebens der Deckschicht (6) die Viskosität des Materials der Deckschicht bei einer Schergeschwindigkeit von 0,94 s⁻¹ bei 40 bis 85 Pa·s liegt.

10. Herstellungsverfahren nach einem der Ansprüche 1 bis 9, wobei der Schritt des Abscheidens der Deckschicht (6) einen Schritt des Einarbeitens von Füllstoffpartikeln, z. B. Siliziumoxid, Aluminiumoxid, Titanoxid und/oder Zirkoniumoxid, in das Material der Grundschicht umfasst.

11. Herstellungsverfahren nach einem der Ansprüche 1 bis 10, wobei das Matrixmaterial Phosphor- und/oder Streupartikel umfasst.

12. Herstellungsverfahren nach einem der Ansprüche 1 bis 11, wobei die LED (3) eine einfarbige und/oder eine mit einem dünnen Phosphorfilm bedeckte LED ist.

13. Leuchtdioden-Modul (1), Folgendes umfassend:
ein Substrat (2),
mindestens eine LED (3), die auf eine Oberfläche des Substrats (2) montiert ist,
eine Grundschicht (5), die für sichtbares Licht durchlässig ist, wobei die Grundschicht (5) die vollständig Oberfläche des Substrats (2) und die LED (3) in engem Kontakt bedeckt und eine Dicke im Bereich von 100 bis 500 µm aufweist,
mindestens eine im Wesentlichen halbkugelförmige Deckschicht (6), welche die LED (3) und nahe gelegene Abschnitte der Grundschicht (5) bedeckt,
wobei ein Winkel des Übergangs von der Grundschicht (5) zur im Wesentlichen halbkugelförmigen Deckschicht (6) im Bereich von 80 bis 90° liegt.

14. LED-Modul (1) nach Anspruch 13, wobei das Substrat eine Leiterplatte (PCB) ist.

15. LED-Modul (1) nach Anspruch 13 oder 14, wobei die LED (3) durch mindestens einen Bonddraht (4) elektrisch mit dem Substrat (2) verbunden ist.

16. LED-Modul (1) nach einem der Ansprüche 13 bis 15, wobei die Grundschicht (5) ein Zwei-Komponenten-Silikonharz ist.

17. LED-Modul (1) nach einem der Ansprüche 13 bis 16, wobei die Grundschicht (5) und/oder die Deckschicht (6) Füllpartikel umfassen/umfasst, z. B. Siliziumoxid, Aluminiumoxid, Titanoxid und/oder Zirkoniumoxid.

18. LED-Modul (1) nach einem der Ansprüche 13 bis 17, wobei die maximale Höhe der im Wesentlichen halbkugelförmigen Deckschicht (6) vorzugsweise im Bereich von 500 bis 1400 µm liegt, bevorzugter im Bereich von 600 bis 1300 µ.

19. LED-Modul (1) nach einem der Ansprüche 13 bis 18, wobei die Breite der LED (3) vorzugsweise im Bereich von 300 bis 1000 µm liegt.

20. LED-Modul (1) nach einem der Ansprüche 13 bis 19, wobei die mindestens eine im Wesentlichen halbkugelförmige Deckschicht (6) Phosphor- und/oder Streupartikel umfasst.

21. LED-Modul (1) nach einem der Ansprüche 13 bis 20, wobei die LED (3) eine einfarbige und/oder eine mit einem dünnen Phosphorfilm (20) bedeckte LED ist.

22. LED-Modul (1) nach einem der Ansprüche 13 bis 21, wobei die Grundschicht (5) keine Phosphorpartikel umfasst.

## Revendications

1. Procédé de fabrication pour un module de diodes électroluminescentes (1), le procédé comprenant les étapes :
de montage d'au moins une DEL (3) sur une surface d'un substrat (2) ;
de dépôt d'une couche de base (5) pour recouvrir complètement ladite surface de substrat (2) et la DEL (3), dans lequel la couche de base (5) est transparente à la lumière visible, et dans lequel l'épaisseur de la couche de base (5) est dans une plage de 100 µm à 500 µm ;
d'exécution d'un premier traitement thermique pour modifier les propriétés de surface de la couche de base (5) ;
de distribution d'un matériau de matrice, de sorte qu'il forme une couche de recouvrement essentiellement semi-sphérique (6) recouvrant la DEL et les parties voisines de la couche de base (5) ;
dans lequel un angle de l'interface entre la couche de base (5) et la couche de recouvrement essentiellement semi-sphérique (6) est dans la plage de 80° à 90° ; et
d'exécution d'un deuxième traitement thermique pour durcir la couche de recouvrement semi sphérique (6).

2. Procédé de fabrication selon la revendication 1, dans lequel la couche de base ne comprend pas de particules de phosphore.

3. Procédé de fabrication selon la revendication 1 ou 2, dans lequel l'étape de dépôt de la couche de base (5) est une étape unique, réalisée par exemple par un revêtement par immersion ou un revêtement par centrifugation.

4. Procédé de fabrication selon l'une quelconque des revendications 1 à 3, dans lequel l'étape de dépôt de la couche de base (5) comprend de multiples étapes, dans lesquelles des petites gouttelettes du matériau de couche de base sont distribuées aux étapes consécutives.

5. Procédé de fabrication selon l'une quelconque des revendications 1 à 4, dans lequel l'étape de dépôt de la couche de base (5) comprend une étape d'incorporation de particules de remplissage, par exemple de silice, d'alumine, de dioxyde de titane et/ou de zircone, dans le matériau de couche de base.

6. Procédé de fabrication selon l'une quelconque des revendications 1 à 5, dans lequel, à l'étape de dépôt de la couche de base (5), la viscosité du matériau de couche de base est dans une plage de 1 Pa.s à 4 Pa.s à une vitesse de cisaillement de 0,94 s⁻¹.

7. Procédé de fabrication selon l'une quelconque des revendications 1 à 6, dans lequel la première étape de traitement thermique est effectuée à environ 80 °C pendant environ 1 heure.

8. Procédé de fabrication selon l'une quelconque des revendications 1 à 7, dans lequel la deuxième étape de traitement thermique est effectuée à environ 150 °C pendant environ 1 heure.

9. Procédé de fabrication selon l'une quelconque des revendications 1 à 8, dans lequel, à l'étape de distribution de la couche de recouvrement (6), la viscosité du matériau de couche de recouvrement est dans une plage de 40 Pa.s à 85 Pa.s à une vitesse de cisaillement de 0,94 s⁻¹.

10. Procédé de fabrication selon l'une quelconque des revendications 1 à 9, dans lequel l'étape de dépôt de la couche de recouvrement (6) comprend une étape d'incorporation de particules de remplissage, par exemple de silice, d'alumine, de dioxyde de titane et/ou de zircone, dans le matériau de couche de base.

11. Procédé de fabrication selon l'une quelconque des revendications 1 à 10, dans lequel le matériau de matrice comprend des particules de phosphore et/ou des particules de pulvérisation.

12. Procédé de fabrication selon l'une quelconque des revendications 1 à 11, dans lequel la DEL (3) est une DEL monochromatique et/ou recouverte d'un film mince de phosphore.

13. Module de diodes électroluminescentes (1) comprenant
un substrat (2) ;
au moins une DEL (3) montée sur une surface du substrat (2) ;
une couche de base (5), qui est transparente à la lumière visible, ladite couche de base (5) recouvrant en contact étroit la surface de substrat (2) complète et la DEL (3) et ayant une épaisseur dans une plage de 100 µm à 500 µm ;
au moins une couche de recouvrement essentiellement semi-sphérique (6), qui recouvre la DEL (3) et les parties voisines de la couche de base (5) ;
dans lequel un angle de l'interface entre la couche de base (5) et la couche de recouvrement essentiellement semi-sphérique (6) est dans la plage de 80° à 90°.

14. Module de DEL (1) selon la revendication 13, dans lequel le substrat est une carte de circuit imprimé, PCB.

15. Module de DEL (1) selon la revendication 13 ou 14, dans lequel la DEL (3) est connectée électriquement au substrat (2) par au moins un fil de liaison (4).

16. Module de DEL (1) selon les revendications 13 à 15, dans lequel la couche de base (5) est une résine de silicone à deux composants.

17. Module de DEL (1) selon l'une quelconque des revendications 13 à 16, dans lequel la couche de base (5) et/ou la couche de recouvrement (6) comprennent des particules de remplissage, par exemple de silice, d'alumine, de dioxyde de titane et/ou de zircone.

18. Module de DEL (1) selon l'une quelconque des revendications 13 à 17, dans lequel la hauteur maximum de la couche de recouvrement essentiellement semi-sphérique (6) est de préférence dans une plage de 500 µm à 1400 µm, plus préférablement dans une plage de 600 µm à 1300 µm.

19. Module de DEL (1) selon l'une quelconque des revendications 13 à 18, dans lequel la largeur de la DEL (3) est de préférence dans une plage de 300 µm à 1000 µm.

20. Module de DEL (1) selon l'une quelconque des revendications 13 à 19, dans lequel ladite au moins une couche de recouvrement essentiellement semi-sphérique (6) comprend des particules de phosphore et/ou des particules de pulvérisation.

21. Module de DEL (1) selon l'une quelconque des revendications 13 à 20, dans lequel la DEL (3) est une DEL monochromatique et/ou recouverte d'un film mince de phosphore (20).

22. Module de DEL (1) selon l'une quelconque des revendications 13 à 21, dans lequel la couche de base (5) ne comprend pas de particules de phosphore.
